# EUROPÄISCHE PATENTANMELDUNG

(11) **EP 3 171 553 A1**
(43) Veröffentlichungstag der Anmeldung: **24.05.2017**
(21) Anmeldenummer: 16198232.7
(22) Anmeldetag: 10.11.2016
(51) Int. Cl.: H04L 12/413, H03M 7/30, H04L 29/08

(54) **VERFAHREN ZUR ÜBERTRAGUNG VON DATEN WENIGSTENS EINES MESSGRÖSSENAUFNEHMERS EINES STEUERNETZWERKS, SENDER, EMPFÄNGER, MESSGRÖSSENAUFNAHMEVORRICHTUNG UND STEUERNETZWERK**

(30) Priorität: 20.11.2015 DE 102015120130
(71) Anmelder: Valeo Schalter und Sensoren GmbH, 74321 Bietigheim-Bissingen (DE)
(72) Erfinder: Bognar, Istvan, 74321 Bietigheim-Bissingen (DE)

(57) **Zusammenfassung**

Es werden ein Verfahren zur Übertragung von Daten wenigstens eines Messgrößenaufnehmers 18 eines Steuernetzwerks 10 mit einem Bussystem 16, einem Sender 20, einem Empfänger 30, einer Messgrößenaufnahmevorrichtung 14 und einem Steuernetzwerk 10 beschrieben. Bei dem Verfahren wird wenigstens ein Teil der Daten mittels wenigstens einem Kompressionsalgorithmus 26 komprimiert. Wenigstens ein Teil der Daten des wenigstens einen Messgrößenaufnehmers 18 wird komprimiert, bevor wenigstens der komprimierte Teil der Daten an das Bussystem 16 übermittelt wird. Mit dem Messgrößenaufnehmer 18 kann ein außerhalb eines Fahrzeugs befindliches Objekt 24 erfasst und eine Entfernung 22 zu diesem bestimmt werden. Die Entfernung 22 kann in Form von Abstandsdaten an den Sender 20 übermittelt werden. Bei dem Komprimierer 26 kann es sich um einen Golomb-Rice-Kodierer handeln. Ferner umfasst der Sender 20 einen Kodierer 28, mit dem in ein geeignetes Format für das Bussystem 16, beispielhaft ein CAN-Datenformat, gebracht werden können. Das Steuergerät 12 weist den Empfänger 30 und eine zentrale Steuereinheit 32 auf. Der Empfänger 30 umfasst einen Dekodierer 34, mit dem empfangene CAN-Daten-Frames dekodiert werden können und die darinn enthaltenen komprimierten Abstandsdaten extrahiert werden können. Ferner umfasst der Empfänger 30 einen Dekomprimierer 36, mit demextrahierten komprimierten Abstandsdaten dekomprimiert werden können. Der Empfänger 30 ist mit der zentralen Steuereinheit 32 verbunden. Die zentrale Steuereinheit 32 umfasst Mechanismen zur Regelung und/oder Steuerung von Funktionen des Fahrzeugs, beispielsweise zur Motorsteuerung, zur Steuerung der Lenkung und/oder zur Steuerung von Bremsfunktionen, und/oder zur Ausgabe von akustischen und/oder optischen Signalen, beispielsweise Warnsignalen. Das Steuergerät 12 ist hierzu beispielhaft mittels entsprechenden Bussystemen 38 mit Knoten 40 verbunden, welche beispielsweise zu dem Bremssystem, dem Lenkungssystem, der Motorsteuerung oder Signalausgabeeinrichtungen des Kraftfahrzeugs gehören oder führen. Bei dem erfindungsgemäßen Verfahren werden die Daten bereits innerhalb des Steuernetzwerks frühzeitig komprimiert, um den Datentransport innerhalb des Bussystems zu verbessern, insbesondere zu beschleunigen und effizienter zu gestalten.

## Beschreibung

### Technisches Gebiet

Die Erfindung betrifft ein Verfahren zur Übertragung von Daten wenigstens eines Messgrößenaufnehmers eines Steuernetzwerks mit einem Bussystem, bei dem wenigstens ein Teil der Daten mittels wenigstens einem Kompressionsalgorithmus komprimiert wird.

Ferner betrifft die Erfindung einen Sender eines Steuernetzwerks mit wenigstens einem Bussystem zur Übermittlung von Daten wenigstens eines Messgrößenaufnehmers.

Außerdem betrifft die Erfindung einen Empfänger eines Steuernetzwerks mit wenigstens einem Bussystem zum Empfang von Daten wenigstens eines Messgrößenaufnehmers.

Darüber hinaus betrifft die Erfindung eine Messgrößenaufnahmevorrichtung mit wenigstens einem Messgrößenaufnehmer und wenigstens einem Sender.

Im Übrigen betrifft die Erfindung ein Steuernetzwerk mit wenigstens einer Steuereinrichtung und wenigstens einem Messgrößenaufnehmer, welche über wenigstens ein Bussystem zur Datenübertragung verbunden sind.

### Stand der Technik

Aus der US 8010704 B2 ist eine Methode zur Kompression von Messdaten bekannt, welche die Gruppierung von gemeinsamen Datenelementen in gemeinsamen Datenbotschaften umfasst. Fortlaufende Datenelemente in den Gruppen werden voneinander subtrahiert, um Differenzwerte bereitzustellen. Die Differenzwerte werden mithilfe eines geeigneten Kompressionsalgorithmus komprimiert, um komprimierte Datenblöcke zu erhalten. Zeitstempelperioden, die zu jeder gemeinsamen Datenbotschaft zugehörig sind, werden ebenso voneinander subtrahiert, um Zeitstempeldifferenzwerte zu erhalten. Die Zeitstempeldifferenzwerte werden ebenfalls komprimiert, um komprimierte Zeitstempelblöcke zu erhalten. Die komprimierten Datenblöcke und Zeitstempelblöcke werden dann gespeichert. Zur Komprimierung wird der Burrows-Wheeler-Kompressionsalgorithmus oder der Huffman-Kompressionsalgorithmus verwendet. Das Kompressionsverfahren kann insbesondere zur Kompression von Messdaten von einem Fahrzeug-CAN-Datenbus verwendet werden. Die Daten werden dabei hinter dem Ausgang des CAN-Datenbusses komprimiert und gespeichert.

Der Erfindung liegt die Aufgabe zugrunde ein Verfahren, einen Sender, einen Empfänger, eine Messgrößenaufnahmevorrichtung und ein Steuernetzwerk der eingangs genannten Art zu gestalten, bei denen eine möglichst schnelle und effiziente Datenübertragung im Steuernetzwerk ermöglicht wird.

### Offenbarung der Erfindung

Diese Aufgabe wird erfindungsgemäß dadurch gelöst, dass wenigstens ein Teil der Daten des wenigstens einen Messgrößenaufnehmers komprimiert wird, bevor wenigstens der komprimierte Teil der Daten an das Bussystem übermittelt wird.

Erfindungsgemäß wird wenigstens ein Teil der Daten bezüglich des Bussystems aufseiten des wenigstens einen Messgrößenaufnehmers komprimiert. Der wenigstens eine Teil der Daten wird komprimiert, bevor die Daten dem Bussystem zugeführt werden. Auf diese Weise kann mit dem Bussystem eine größere Datenmenge und/oder die Datenmenge mit einer höheren Geschwindigkeit übertragen werden. Die vorhandenen Datenleitungen können effizienter genutzt werden. Alternativ kann das Bussystem insgesamt entlastet werden. Die Anzahl der erforderlichen Datenleitungen des Bussystems kann insgesamt geringer sein als bei der Übertragung von unkomprimierten Daten. Es können auch mehrere Busleitungen zusammengelegt werden. Es können mehr Daten bei gleicher Buslast verschickt werden. Dies kann bei der Fusion von Steuergerätedaten die Effizienz und Geschwindigkeit der Datenübertragung erhöhen. Insbesondere bei der Fusion von Steuergerätedaten können mehrere, insbesondere alle beteiligten Steuergeräte gleichartige Daten untereinander austauschen.

Im Unterschied zu dem erfindungsgemäßen Verfahren wird das aus dem Stand der Technik bekannte Kompressionsverfahren verwendet um Daten, die das Bussystem verlassen, zu komprimieren, um außerhalb des Steuernetzwerks Speicherplatz zu sparen. Bei dem erfindungsgemäßen Verfahren werden die Daten bereits innerhalb des Steuernetzwerks frühzeitig komprimiert, um den Datentransport innerhalb des Bussystems zu verbessern, insbesondere zu beschleunigen und effizienter zu gestalten.

Bei einer vorteilhaften Ausführungsform kann wenigstens der komprimierte Teil der Daten mit dem Bussystem an wenigstens einen weiteren Knoten innerhalb des Steuernetzwerks übermittelt werden. Wenigstens die komprimierten Daten stehen so aufseiten des wenigstens einen weiteren Knotens innerhalb des Steuernetzwerks zur Verfügung.

Vorteilhafterweise kann eine Übertragungsgeschwindigkeit für die komprimierten Daten gegenüber der Übertragungsgeschwindigkeit von unkomprimierten Daten erhöht werden. So kann in vergleichbaren Zeitintervallen eine größere Datenmenge übertragen werden. Daten des wenigstens einen Messgrößenaufnehmers können so auch ungefiltert über das wenigstens eine Bussystem übertragen werden.

Vorteilhafterweise kann wenigstens ein Teil der übermittelten komprimierten Daten aufseiten des wenigstens einen weiteren Knotens innerhalb des Steuernetzwerks mittels wenigstens einem entsprechenden Dekompressionsalgorithmus dekomprimiert werden. Die dekomprimierten Daten können so aufseiten des wenigstens einen weiteren Knotens in Reinform verwendet werden.

Wenigstens ein weiterer Knoten des Steuernetzwerks kann vorteilhafterweise mit wenigstens einer Steuereinrichtung, insbesondere einem Steuergerät oder einer Steuereinheit, insbesondere eines Fahrzeugs, realisiert sein.

Wenigstens ein Dekompressionsalgorithmus zum Dekomprimieren der komprimierten Daten kann einfach und effizient aufseiten eines Steuergeräts oder innerhalb des Steuergeräts des Fahrzeugs implementiert werden. Dazu können ohnehin vorhandene Prozessoren und/oder Algorithmen verwendet werden.

Bei einer weiteren vorteilhaften Ausgestaltung des Verfahrens kann wenigstens ein Teil der Daten des wenigstens einen Messgrößenaufnehmers mittels einer Entropiekodierung, insbesondere einer Lauflängenkodierung, und/oder einer Golomb-Kodierung und/oder einer Golomb-Rice-Kodierung komprimiert werden. Mit derartigen Kodierungen können die Daten einfach verlustfrei komprimiert werden.

Mit einer Entropiekodierung, insbesondere einer Lauflängenkodierung, kann jedem einzelnen Zeichen eines Datensatzes eine unterschiedlich lange Folge von Bits zugeordnet werden. Mit einer Entropiekodierung, insbesondere einer Lauflängenkodierung, können insbesondere längere Wiederholungen von Symbolen einfach und effizient komprimiert werden.

Vorteilhafterweise kann wenigstens ein Teil der Daten mittels einer an sich bekannten Golomb-Kodierung und/oder einer an sich bekannten Golomb-Rice-Kodierung komprimiert werden. Mit der Golomb-Kodierung und der Golomb-Rice-Kodierung können die Daten effizient mit verhältnismäßig wenig Bits dargestellt werden. Im Unterschied zu andersartigen bekannten Komprimierungen kann mit dem Golomb-Kode ein endlicher Wertebereich effizient dargestellt werden. Mit der Golomb-Kodierung kann eine darzustellende Zahl durch einen Quotienten und den Rest bei einer Division mit einem Parameter ersetzt werden.

Der Golomb-Rice-Kode ist bekanntermaßen eine Variante des Golomb-Kodes. Dabei ist der Parameter eine Zweierpotenz. Diese Einschränkung ist von Vorteil, da insbesondere in der digitalen Verarbeitung die Multiplikation beziehungsweise Division von 2 sehr effizient implementiert werden kann. So kann der entsprechende Kompressionsalgorithmus sehr einfach, insbesondere mittels Bit-Shiften und logischen Bit-Operationen, umgesetzt werden. Golomb-Rice-Kodierungen können besonders effizient bei Busformaten, insbesondere CAN-Busformaten, eingesetzt werden, bei denen positive, ganzzahlige Werte in einem endlichen Wertebereich übermittelt werden sollen. Die Golomb-Rice-Kodierung kann so besonders effizient in Verbindung mit digitalen Steuergeräten verwendet werden und einfach dort implementiert werden.

Eine Golomb-Kodierung und eine Golomb-Rice-Kodierung können einfach mit geringem Rechenaufwand realisiert werden. Ferner kann eine derartige Komprimierung und Dekomprimierung von Daten mit einem verhältnismäßig geringen Speicheraufwand im Vergleich zu anderen Komprimierungsarten, wie beispielsweise der Huffman-Kodierung, realisiert werden.

Eine Golomb-Kodierung und eine Golomb-Rice-Kodierung kann einfach auch in bereits vorhandene Prozessorsysteme und/oder Algorithmen, insbesondere aufseiten des wenigstens einen Messgrößenaufnehmers beziehungsweise aufseiten des wenigstens einen weiteren Knotens, implementiert werden.

Eine Implementierung eines Kompressionsalgorithmus mit dem Golomb-Rice-Kode kann bei sogenannten eingebetteten Systemen (embedded Systems) effizient realisiert werden, um mit einfachen Bit-Maskierungen eine Datenkompression zu erreichen. Bei eingebetteten Systemen ist ein elektronischer Rechner, insbesondere ein Steuergerät, in einen technischen Kontext eingebunden. Derartige eingebettete Systeme sind insbesondere in der Fahrzeugtechnik weit verbreitet.

Zusätzlich oder alternativ zu der Entropiekodierung, insbesondere der Lauflängenkodierung, der Golomb-Kodierung und/oder der Golomb-Rice-Kodierung kann wenigstens ein Teil der Daten auch mit einem andersartigen Kompressionsverfahren oder Kompressionsalgorithmus, insbesondere mittels einer Burrows-Wheeler-Transformation, einer Delta-Kodierung, einer Häufigkeits-Substitution (frequency substitution), einer Huffman-Kodierung, einem Lempel-Ziv-Storer-Szymanski-Algorithmus (LZSS), einer Lempel-Ziv-Welch-Algorithmus (LZW) oder dergleichen, komprimiert werden.

Bei einer weiteren vorteilhaften Ausgestaltung des Verfahrens kann wenigstens ein Teil der Daten des wenigstens einen Messgrößenaufnehmers fortlaufend und/oder in Echtzeit übertragen, insbesondere komprimiert und/oder übermittelt und/oder dekomprimiert, werden. Eine fortlaufende Übertragung hat den Vorteil, dass die Daten kontinuierlich an entsprechende Knoten des Steuernetzwerks übertragen werden können. So können entsprechende Steuerfunktionen insbesondere des Fahrzeugs kontinuierlich abhängig von äußeren Umständen, insbesondere dem Vorhandensein und/oder Entfernungen von Objekten, verändert werden.

Alternativ oder zusätzlich kann wenigstens ein Teil der Daten in Echtzeit übertragen werden. Die Daten können so zuverlässig innerhalb des Zeitrasters des Steuernetzwerks geliefert werden. Auf zusätzliche Datenspeicher zur Zwischenspeicherung der Daten kann verzichtet werden.

Bei einer weiteren vorteilhaften Ausgestaltung des Verfahrens kann wenigstens ein Teil der komprimierten Daten in ein für das Bussystem geeignetes Format, insbesondere ein Feldbusformat, insbesondere ein CAN-Bus-Format, übertragen, insbesondere kodiert, werden. Auf diese Weise können die komprimierten Daten mit weiteren Informationen, insbesondere Identifikationsdaten des wenigstens einen Messgrößenaufnehmers, Information über Beginn und Ende der Nachricht oder dergleichen, versehen werden.

Vorteilhafterweise können die komprimierten Daten des wenigstens einen Messgrößenaufnehmers in einem sogenannten Telegrammrahmen (Frame) angeordnet werden.

Vorteilhafterweise können die komprimierten Daten in ein Feldbusformat angeordnet werden. Auf diese Wiese können die Daten mit einem so genannten Feldbus ausgetauscht werden. Mit Feldbussen können Feldgeräte wie der wenigstens eine Messgrößenaufnehmer, Stellglieder oder dergleichen mit einem Automatisierungs- oder Steuergerät verbunden werden.

Vorteilhafterweise können die Daten in ein so genanntes CAN-Datentelegramm für einen so genannten CAN-Bus (Controller Area Network) übertragen werden. In CAN-Bussen können die Daten seriell übertragen werden. Die komprimierten Daten können in einem Datenfeld des sogenannten CAN-Telegrammrahmens (CAN-Frames) angeordnet sein. Aufgrund der vorherigen Kompression mithilfe des wenigstens einen Kompressionsalgorithmus können in dem üblichen Datenfeld deutlich mehr Informationen angeordnet und übermittelt werden als ohne Kompression.

Bei Standard CAN-Datentelegrammen werden positive, ganzzahlige Werte aus einem endlichen Wertebereich verwendet. Eine Komprimierung und Dekomprimierung mithilfe eines Golomb-Rice-Algorithmus kann daher besonders effizient eingesetzt werden.

Alternativ oder zusätzlich kann wenigstens ein Teil der komprimierten Daten in ein andersartiges Format übertragen werden, welches für andersartige Bussysteme, insbesondere FlexRay-Busse, CAN-FD-Busse, MOST-Busse, LIN-Busse, Ethernet-Busse oder dergleichen, geeignet ist.

Bei einer weiteren vorteilhaften Ausgestaltung des Verfahrens kann wenigstens ein Teil der Daten des wenigstens einen Messgrößenaufnehmers in einem Binärkode übertragen, insbesondere komprimiert und/oder übermittelt und/oder dekomprimiert, werden. Auf diese Weise können die Daten besonders einfach komprimiert, übermittelt und/oder dekomprimiert werden. Insbesondere bei Verwendung von Binärkodes kann eine Komprimierung und Dekomprimierung mithilfe des Golomb-Rice-Kodes besonders einfach realisiert werden.

Bei einer weiteren vorteilhaften Ausgestaltung des Verfahrens kann wenigstens ein Teil der Daten des wenigstens einen Messgrößenaufnehmers aus Signalen des wenigstens einen Messgrößenaufnehmers ermittelt werden, welche wenigstens einen von dem wenigstens einen Messgrößenaufnehmer erfassten Zustand insbesondere der Umgebung charakterisieren. Mit dem wenigstens einen Messgrößenaufnehmer können sogenannte Umweltdaten erfasst werden. Mit dem wenigstens einen Messgrößenaufnehmer kann insbesondere das Vorhandensein von Objekten im Erfassungsbereich des wenigstens einen Messgrößenaufnehmers ermittelt werden. Gegebenenfalls kann eine Entfernung eines etwaigen Objektes zu dem Messgrößenaufnehmer ermittelt werden. Dabei können entsprechende Abstandsdaten realisiert werden, welche mit dem erfindungsgemäßen Verfahren übertragen, insbesondere komprimiert, kodiert, übermittelt, dekomprimiert und/oder dekodiert, werden können.

Der wenigstens eine Messgrößenaufnehmer kann vorteilhafterweise auf Radartechnik, Lasertechnik, Ultraschalltechnik, bildgebende Systeme, insbesondere Kamerasysteme, oder dergleichen basieren. Der wenigstens eine Messgrößenaufnehmer kann als Abstandsmesser ausgestaltet sein. Der wenigstens eine Messgrößenaufnehmer kann insbesondere wenigstens einen Radarsensor, einen Laserscanner, ein Ultraschallmesssystem oder dergleichen aufweisen oder daraus bestehen.

Mit dem erfindungsgemäßen Verfahren können Daten von so genannten Raw-Object-Listen (ROL) über das Bussystem versendet werden. Das erfindungsgemäße Verfahren ermöglicht eine kontinuierliche Übermittlung von Rohdaten, insbesondere ungefilterten Daten, des wenigstens einen Messgrößenaufnehmers, insbesondere von mehreren Messgrößenaufnehmern. Dabei können dank der Erfindung mehrere Messgrößenaufnehmer mit einer gemeinsamen Busleitung Daten zu dem entsprechenden wenigstens einen weiteren Knoten übermitteln. Es ist nicht erforderlich, dass jedem Messgrößenaufnehmer eine eigene Busleitung zugeordnet ist.

Bei einer weiteren vorteilhaften Ausgestaltung des Verfahrens können Daten innerhalb eines Steuernetzwerks eines Fahrzeugs übertragen werden. Auf diese Weise können Daten des wenigstens einen Messgrößenaufnehmers zur Steuerung von Funktionen des Fahrzeugs verwendet werden.

Vorteilhafterweise kann das Steuernetzwerk wenigstens eine Steuereinrichtung, insbesondere ein Steuergerät, aufweisen. Die wenigstens eine Steuereinrichtung kann wenigstens einen weiteren Knoten des Bussystems realisieren. Mit der wenigstens einen Steuereinrichtung können abhängig von den Daten des wenigstens einen Messgrößenaufnehmers entsprechende Funktionen des Fahrzeugs gesteuert werden.

Vorteilhafterweise kann das Steuernetzwerk wenigstens ein System zur Fahrkontrolle des Fahrzeugs, insbesondere ein Bremssystem, ein Lenkungssystem und/oder eine Motorsteuerung, aufweisen oder damit verbunden sein. Wenigstens ein System zur Fahrkontrolle kann wenigstens einen Knoten desselben oder eines weiteren Bussystems aufweisen oder bilden, welcher mit dem der wenigstens einen Steuereinrichtung verbunden sein kann. Alternativ oder zusätzlich kann das Steuernetzwerk mit wenigstens einer Einrichtung zur Ausgabe eines optischen und/oder akustischen Signals, insbesondere eines Warnsignals, verbunden sein oder diese aufweisen.

Vorteilhafterweise können Abstandsdaten zu Objekten im Erfassungsbereich des wenigstens einen Messgrößenaufnehmers erfindungsgemäß übermittelt und zur Steuerung von Fahrfunktionen des Fahrzeugs, insbesondere zum Bremsen, Richtungswechsel und/oder Fahren, herangezogen werden. Die Erfindung kann auch bei so genanntem Einparkhilfen Verwendung finden.

Ferner wird die Aufgabe erfindungsgemäß durch den Sender dadurch gelöst, dass der Sender bezüglich des Bussystems aufseiten wenigstens eines Messgrößenaufnehmers angeordnet ist oder werden kann und der Sender wenigstens einen Komprimierer umfasst zum Komprimieren wenigstens eines Teils der Daten des wenigstens einen Messgrößenaufnehmers. Mit dem Sender kann wenigstens ein Teil der Daten des Messgrößenaufnehmers übertragen werden, insbesondere komprimiert und/oder in ein entsprechendes Datenformat gebracht werden.

Vorteilhafterweise kann wenigstens ein Komprimierer und/oder Kodierer zur Binärcodierung von Daten des wenigstens einen Messgrößenaufnehmers ausgestaltet sein.

Bei einer vorteilhaften Ausführungsform kann wenigstens ein Komprimierer wenigstens einen Entropiekodierer, insbesondere einen Lauflängenkodierer, und/oder wenigstens einen Golomb-Kodierer und/oder wenigstens einen Golomb-Rice-Kodierer aufweisen. So kann wenigstens ein Teil der Daten mit dem jeweils entsprechenden Kompressionsalgorithmus komprimiert werden.

Bei einer weiteren vorteilhaften Ausführungsform kann der Sender ausgestaltet sein zur Verwendung mit einem Feldbussystem, insbesondere einem CAN-Bussystem, einem FlexRay-Bussystem, einem CAN-FD-Bussystem, eine MOST-Bussystem, LIN-Bussystem, Ethernet-Bussystem oder dergleichen.

Vorteilhafterweise kann der Sender und/oder der wenigstens eine Messgrößenaufnehmer mit anderen Komponenten des Steuernetzwerks vernetzt oder vernetzbar sein.

Vorteilhafterweise kann der Sender mittels wenigstens einem Bussystem mit wenigstens einem Empfänger des Steuernetzwerks signaltechnisch verbunden oder verbindbar sein.

Außerdem wird die Aufgabe erfindungsgemäß durch den Empfänger dadurch gelöst, dass der Empfänger wenigstens einen Dekomprimierer umfasst zum Dekomprimieren wenigstens eines Teils von komprimierten Daten des wenigstens einen Messgrößenaufnehmers. Mit dem Empfänger können die komprimierten Daten mit dem entsprechenden Dekomprimieralgorithmus dekomprimiert werden.

Der Empfänger kann vorteilhafterweise einem weiteren Knoten des Bussystems zugeordnet sein oder werden. Vorteilhafterweise kann der Empfänger auf der dem wenigstens einen Messgrößenaufnehmers signaltechnisch abgewandten Seite des Bussystems angeordnet sein oder werden. Vorteilhafterweise kann der Empfänger einer Steuereinrichtung des Steuernetzwerks zugeordnet sein.

Darüber hinaus wird die Aufgabe erfindungsgemäß durch die Messgrößenaufnahmevorrichtung dadurch gelöst, dass die Messgrößenaufnahmevorrichtung wenigstens einen Komprimierer umfasst zum Komprimieren wenigstens eines Teils der Daten des wenigstens einen Messgrößenaufnehmers. Der wenigstens eine Komprimierer kann integraler Bestandteil des Messgrößenaufnehmers und/oder des Senders sein. Außerdem kann der Sender integraler Bestandteil des Messgrößenaufnehmers sein oder umgekehrt.

Vorteilhafterweise kann die Messgrößenaufnahmevorrichtung mit wenigstens einem Messgrößenaufnehmer, wenigstens einem Sender und wenigstens einem Komprimierer als Modul realisiert sein.

Im Übrigen wird die Aufgabe erfindungsgemäß durch das Steuernetzwerk dadurch gelöst, dass bezüglich des Bussystems aufseiten des wenigstens einen Messgrößenaufnehmers wenigstens ein Komprimierer zum Komprimieren wenigstens eines Teils von Daten des wenigstens einen Messgrößenaufnehmers angeordnet ist und aufseiten der wenigstens einen Steuereinrichtung wenigstens ein Dekomprimierer zum Dekomprimieren wenigstens eines Teils der komprimierten Daten des wenigstens eine Messgrößenaufnehmers angeordnet ist. Auf diese Weise kann innerhalb des Steuernetzwerks wenigstens ein Teil der Daten effizient und schnell übertragen, insbesondere komprimiert, versendet und dekomprimiert, werden.

Im Übrigen gelten die im Zusammenhang mit dem erfindungsgemäßen Verfahren, dem erfindungsgemäßen Sender, dem erfindungsgemäßen Empfänger, der erfindungsgemäßen Messgrößenaufnahmevorrichtung und dem erfindungsgemäßen Steuernetzwerk und deren jeweiligen vorteilhaften Ausgestaltungen aufgezeigten Merkmale und Vorteile untereinander entsprechend und umgekehrt. Die einzelnen Merkmale und Vorteile können selbstverständlich untereinander kombiniert werden, wobei sich weitere vorteilhafte Wirkungen einstellen können, die über die Summe der Einzelwirkungen hinausgehen.

### Kurze Beschreibung der Zeichnungen

Weitere Vorteile, Merkmale und Einzelheiten der Erfindung ergeben sich aus der nachfolgenden Beschreibung, in der ein Ausführungsbeispiel der Erfindung anhand der Zeichnung näher erläutert wird. Der Fachmann wird die in der Zeichnung, der Beschreibung und den Ansprüchen in Kombination offenbarten Merkmale zweckmäßigerweise auch einzeln betrachten und zu sinnvollen weiteren Kombinationen zusammenfassen.

Es zeigen schematisch
- Figur 1: ein Steuernetzwerk eines Fahrzeugs mit einer Messgrößenaufnahmevorrichtung, die mittels einem Bussystem mit einem Steuergerät signaltechnisch verbunden ist;
- Figur 2: ein Ablaufdiagramm eines Verfahrens zur Übertragung von Abstandsdaten eines Messgrößenaufnehmers der Messgrößenaufnahmevorrichtung an das Steuergerät des Steuernetzwerks aus der Figur 1.

In den Figuren sind gleiche Bauteile mit gleichen Bezugszeichen versehen.

### Ausführungsform(en) der Erfindung

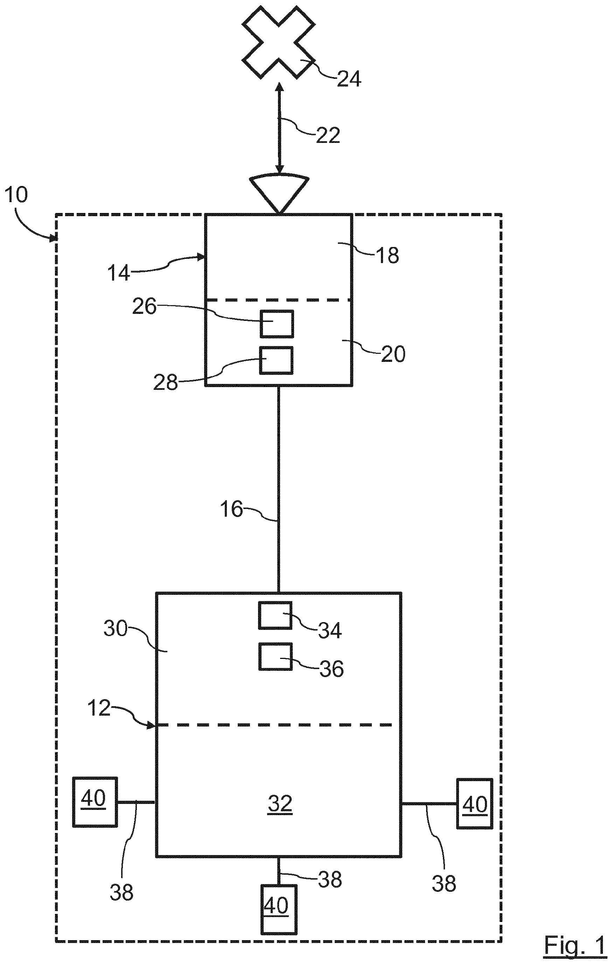

In der Figur 1 ist ein Steuernetzwerk 10 eines ansonsten nicht gezeigten Fahrzeugs, beispielsweise eines Kraftfahrzeugs, schematisch gezeigt. Das Steuernetzwerk 10 umfasst ein Steuergerät 12, in der Figur 1 unten, und eine Messgrößenaufnahmevorrichtung 14, oben. Die Messgrößenaufnahmevorrichtung 14 ist mittels eines Bussystems 16 signaltechnisch mit dem Steuergerät 12 verbunden.

Die Messgrößenaufnahmevorrichtung 14 umfasst einen Messgrößenaufnehmer 18 und einen Sender 20. Der Messgrößenaufnehmer 18 kann beispielhaft als Laserscanner, Radarsystem, Ultraschallmesssystem, bildgebendes System, beispielsweise Kamerasystem, oder dergleichen ausgestaltet sein. Mit dem Messgrößenaufnehmer 18 kann ein außerhalb des Fahrzeugs befindliches Objekt 24 erfasst und eine Entfernung 22 zu diesem bestimmt werden. Die Entfernung 22 kann in hier nicht weiter interessierender Weise in Form von Abstandsdaten an den Sender 20 übermittelt werden.

Der Sender 20 umfasst einen Komprimierer 26, mit dem die Abstandsdaten mittels einem Kompressionsalgorithmus komprimiert werden können. Bei dem Komprimierer 26 kann es sich um einen an sich bekannten Golomb-Rice-Kodierer handeln. Mit dem Golomb-Rice-Kodierer können die Abstandsdaten mit einem Kompressionsalgorithmus eines sich bekannten Golomb-Rice-Kodes komprimiert werden. Es kann zusätzlich oder alternativ auch ein andersartiger Komprimierer eingesetzt werden, beispielsweise auf Basis einer andersartigen einen Entropiekodierung, insbesondere Lauflängenkodierung, einer Burrows-Wheeler-Transformation, einer Delta-Kodierung, einer Häufigkeits-Substitution, einer Huffman-Kodierung, einem Lempel-Ziv-Storer-Szymanski-Algorithmus oder einem Lempel-Welch-Algorithmus. Es können auch mehrere Komprimierungs- und/oder Kodierungsalgorithmen ausgeführt werden.

Ferner umfasst der Sender 20 einen Kodierer 28. Mit dem Kodierer 28 können die komprimierten Abstandsdaten mittels kodieren in ein geeignetes Format für das Bussystem 16, beispielhaft ein CAN-Datenformat, gebracht werden.

Bei dem Bussystem 16 kann es sich beispielhaft um ein Feldbussystem, beispielsweise um ein an sich bekanntes Controller-Area-Network-Bussystem (CAN-Bussystem), handeln. Es können auch andersartige Bussysteme, beispielsweise FlexRay-Bussysteme, CAN-FD-Bussysteme, MOST-Bussysteme, LIN-Bussysteme, Ethernet-Bussysteme oder dergleichen, Verwendung finden. Bei dem CAN-Bussystem handelt es sich um ein serielles Bussystem. Das Bussystem 16 kann mit Kabelbäumen realisiert sein. Andersartige Bussysteme können auch mit andersartigen Datenleitungsmechanismen, beispielsweise Glasfaser oder Funkübertragung oder dergleichen, realisiert werden. An das Bussystem 16 sind in dem vorliegenden Beispiel das Steuergerät 12 und die Messgrößenaufnahmevorrichtung 14 als jeweilige Knoten angeschlossen.

Die Daten von der Messgrößenaufnahmevorrichtung 14 werden in an sich bekannten Datentelegrammen (CAN-Daten-Frames) übertragen. Die CAN-Daten-Frames basieren auf Binärdarstellungen. Die komprimierten Abstandsdaten sind in einem Datenfeld des jeweiligen CAN-Daten-Frames angeordnet. In einem üblichen CAN-Daten-Frame können bis zu 8 Byte an Daten, vorliegend beispielhaft die komprimierten Abstandsdaten, in dem Datenfeld untergebracht werden. Das Datenfeld ist unter anderem zwischen Steuerbits angeordnet. Mit den Steuerbits kann das Datentelegramm beispielsweise identifiziert und Anfang und Ende des Datentelegramms definiert werden. Die einzelnen Bits des CAN-Daten-Frames können bekanntermaßen mithilfe von elektrischen Spannungs-Signalen mit dem Bussystem 16 übermittelt werden.

Das Steuergerät 12 weist einen Empfänger 30 und eine zentrale Steuereinheit 32 auf.

Der Empfänger 30 umfasst einen Dekodierer 34. Mit den Dekodierer 34 können empfangene CAN-Daten-Frames dekodiert werden. Darin enthaltenen komprimierten Abstandsdaten können so extrahiert werden.

Ferner umfasst der Empfänger 30 einen Dekomprimierer 36. Mit den Dekomprimierer 36 können die extrahierten komprimierten Abstandsdaten dekomprimiert werden. Der Dekomprimierer 36 arbeitet mit einem Dekodieralgorithmus, der geeignet ist, um die Kodierung des Komprimierers 26 zu dekodieren. Im vorliegenden Ausführungsbeispiel arbeitet der Dekomprimierer 36 mit einem Golomb-Rice-Dekodierer.

Der Empfänger 30 ist signaltechnisch mit der zentralen Steuereinheit 32 verbunden. Die zentrale Steuereinheit 32 umfasst Mechanismen, beispielsweise Regel- und/oder Steueralgorithmen, zur Regelung und/oder Steuerung von Funktionen des Fahrzeugs, beispielsweise zur Motorsteuerung, zur Steuerung der Lenkung und/oder zur Steuerung von Bremsfunktionen, und/oder zur Ausgabe von akustischen und/oder optischen Signalen, beispielsweise Warnsignalen. Das Steuergerät 12 ist hierzu beispielhaft mittels entsprechenden Bussystemen 38 mit Knoten 40 verbunden, welche beispielsweise zu dem Bremssystem, dem Lenkungssystem, der Motorsteuerung oder Signalausgabeeinrichtungen des Kraftfahrzeugs gehören oder führen.

Der Komprimierer 26 und der Kodierer 28 können beispielhaft mittels integrierter Schaltungen in dem Sender 20 eingebettet sein. Der Sender 20 kann in den Messgrößenaufnehmer 18 integriert oder eingebettet sein oder umgekehrt. Wenigstens Teile der Funktionen des Senders 20, nämlich die Kodierung und Versendung der Daten, und des Messgrößenaufnehmers 18, nämlich die Datenerfassung und Digitalisierung, können dabei in einer gemeinsamen Schaltung oder miteinander verbundenen Schaltungen realisiert sein. Entsprechend können der Empfänger 30, der Dekodierer 34 und der Dekomprimierer 36 integriert, eingebettet oder in anderer Weise miteinander kombiniert sein. Der Empfänger 30 seinerseits kann entsprechend in der zentralen Steuereinheit 32 integriert, eingebettet oder in anderer Weise mit dieser kombiniert sein. Der Komprimierer 26, der Kodierer 28, der Dekodierer 34 und der Dekomprimierer 36 können mit Rechenroutinen realisiert sein. Sie können in entsprechende Programme oder ein einziges Programm implementiert sein. Der Komprimierer 26 und der Kodierer 28 können auch durch einen integrierten Komprimierer-Kodierer-Algorithmus realisiert sein. Entsprechend können der Dekodierer 34 und der Dekomprimierer 36 durch einen integrierten Dekodierer-Dekomprimierer-Algorithmus realisiert sein.

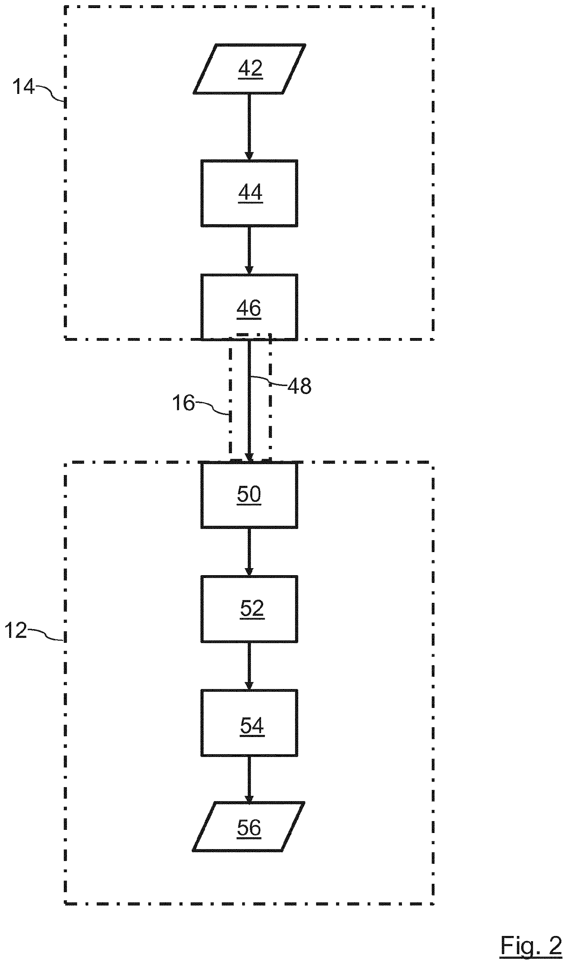

Ein beispielhaftes Verfahren zur Übertragung der Abstandsdaten des Messgrößenaufnehmers 18 zu der zentralen Steuereinheit 32 wird im Folgenden anhand des Ablaufdiagramms aus der Figur 2 exemplarisch für einen Satz von Abstandsdaten erläutert. Ein Satz von Abstandsdaten wird in einer definierten Zeitspanne innerhalb eines Zeitrasters erfasst. Der Satz von Abstandsdaten gibt innerhalb der definierten Zeitspanne einen momentanen Zustand der Umgebung, insbesondere einen Abstand zu dem Objekt 24 wieder. Besagte definierte Zeitspanne kann sich beispielsweise in der Größenordnung von Millisekunden bewegen.

Der Satz von Abstandsdaten aus dem Messgrößenaufnehmer 18 wird in einem Schritt 42 erfasst. Die Abstandsdaten werden anschließend an den Komprimierer 26 übermittelt. Mit dem Komprimierer 26 werden die Abstandsdaten in einem Schritt 44 mit dem Kompressionsalgorithmus mit der Golomb-Rice-Kodierung komprimiert. Die komprimierten Abstandsdaten liegen in einer Binärdarstellung vor.

Die komprimierten Abstandsdaten werden an den Kodierer 28 übermittelt. Mit dem Kodierer 28 werden in einem Schritt 46 die komprimierten Abstandsdaten in ein entsprechendes CAN-Daten-Frame kodiert.

Statt in den zwei Schritten 44 und 46 kann die Komprimierung und Kodierung der Abstandsdaten auch in einem gemeinsamen Schritt beispielsweise mit einem kombinierten Komprimierer-Kodierer erfolgen.

Das CAN-Daten-Frame wird an das Bussystem 16 übergeben und mit diesem in einem Schritt 48 an das Steuergerät 12 übermittelt.

Das CAN-Daten-Frame wird an den Dekodierer 34 des Empfängers 30 übermittelt. In einem Schritt 50 werden mit dem Dekodierer 34 das CAN-Daten-Frame entschlüsselt und die komprimierten Abstandsdaten extrahiert.

Die extrahierten komprimierten Abstandsdaten werden an den Dekomprimierer 36 übermittelt. Mit dem Dekomprimierer 36 werden die komprimierten Abstandsdaten in einem Schritt 52 mit einer an sich bekannten Golomb-Rice-Dekodierung dekomprimiert.

Statt in den zwei Schritten 50 und 52 kann die Dekodierung und die Dekomprimierung der Abstandsdaten auch in einem gemeinsamen Schritt beispielsweise mit einem kombinierten Dekodierer-Dekomprimierer erfolgen.

Die dekomprimierten Abstandsdaten werden an die zentrale Steuereinheit 32 übermittelt. Mit der zentralen Steuereinheit 32 werden die Abstandsdaten in einem Schritt 54 mit entsprechenden Steueralgorithmen verarbeitet. In einem Schritt 56 werden mit dem Steuergerät 12 entsprechende Steuerungsdaten gegebenenfalls über die entsprechenden weiteren Bussysteme 38 und die Knoten 40 übermittelt.

Mit den Einrichtungen an den Knoten 40 werden die entsprechenden Funktionen des Fahrzeugs, beispielsweise Fahren, Bremsen, Richtungswechsel und/oder Signalausgabe bewirkt.

Zumindest die Schritte 4 bis 52 können beispielhaft in Echtzeit erfolgen. Ferner können wenigstens die Schritte 42 bis 52 je nach Bedarf mehrmals, auch kontinuierlich, wiederholt werden. Dabei können nacheinander mehrere Sätze von Abstandsdaten erfasst und übermittelt werden. Auf diese Weise können fortlaufend Abstandsdaten an die Steuereinheit 54 übergeben werden. So kann fortlaufend ein Zustand der Umgebung erfasst und zu entsprechenden Steuerung des Fahrzeugs übertragen werden.

## Patentansprüche

1. Verfahren zur Übertragung von Daten wenigstens eines Messgrößenaufnehmers (18) eines Steuernetzwerks (10) mit einem Bussystem (16), bei dem wenigstens ein Teil der Daten mittels wenigstens einem Kompressionsalgorithmus (26) komprimiert wird, **dadurch gekennzeichnet, dass** wenigstens ein Teil der Daten des wenigstens einen Messgrößenaufnehmers (18) komprimiert wird, bevor wenigstens der komprimierte Teil der Daten an das Bussystem (16) übermittelt wird.

2. Verfahren nach Anspruch 1, **dadurch gekennzeichnet, dass** wenigstens der komprimierte Teil der Daten mit dem Bussystem (16) an wenigstens einen weiteren Knoten (12) innerhalb des Steuernetzwerks (10) übermittelt wird.

3. Verfahren nach Anspruch 1 oder 2, **dadurch gekennzeichnet, dass** wenigstens ein Teil der Daten des wenigstens einen Messgrößenaufnehmers (18) mittels einer Entropiekodierung, insbesondere einer Lauflängenkodierung, und/oder einer Golomb-Kodierung und/oder einer Golomb-Rice-Kodierung (26) komprimiert wird.

4. Verfahren nach einem der vorigen Ansprüche, **dadurch gekennzeichnet, dass** wenigstens ein Teil der Daten des wenigstens einen Messgrößenaufnehmers (18) fortlaufend und/oder in Echtzeit übertragen, insbesondere komprimiert und/oder übermittelt und/oder dekomprimiert, wird.

5. Verfahren nach einem der vorigen Ansprüche, **dadurch gekennzeichnet, dass** wenigstens ein Teil der komprimierten Daten in ein für das Bussystem (16) geeignetes Format, insbesondere ein Feldbusformat, insbesondere ein CAN-Bus-Format, übertragen, insbesondere kodiert, wird.

6. Verfahren nach einem der vorigen Ansprüche, **dadurch gekennzeichnet, dass** wenigstens ein Teil der Daten des wenigstens einen Messgrößenaufnehmers (18) in einem Binärkode übertragen, insbesondere komprimiert und/oder übermittelt und/oder dekomprimiert, wird.

7. Verfahren nach einem der vorigen Ansprüche, **dadurch gekennzeichnet, dass** wenigstens ein Teil der Daten des wenigstens einen Messgrößenaufnehmers (18) aus Signalen des wenigstens einen Messgrößenaufnehmers (18) ermittelt wird, welche wenigstens einen von dem wenigstens einen Messgrößenaufnehmer (18) erfassten Zustand insbesondere der Umgebung charakterisieren.

8. Verfahren nach einem der vorigen Ansprüche, **dadurch gekennzeichnet, dass** Daten innerhalb eines Steuernetzwerks (10) eines Fahrzeugs übertragen werden.

9. Sender (20) eines Steuernetzwerks (10) mit wenigstens einem Bussystem (16) zur Übermittlung von Daten wenigstens eines Messgrößenaufnehmers (18), insbesondere zur Durchführung des Verfahrens nach einem der Ansprüche 1 bis 8, **dadurch gekennzeichnet, dass** der Sender (20) bezüglich des Bussystems (16) aufseiten wenigstens eines Messgrößenaufnehmers (18) angeordnet ist oder werden kann und der Sender (20) wenigstens einen Komprimierer (26) umfasst zum Komprimieren (26) wenigstens eines Teils der Daten des wenigstens einen Messgrößenaufnehmers (18).

10. Sender nach Anspruch 9, **dadurch gekennzeichnet, dass** wenigstens ein Komprimierer (26) wenigstens einen Entropiekodierer, insbesondere einen Lauflängenkodierer, und/oder wenigstens einen Golomb-Kodierer und/oder wenigstens einen Golomb-Rice-Kodierer aufweist.

11. Sender nach Anspruch 9 oder 10, **dadurch gekennzeichnet, dass** der Sender (20) ausgestaltet ist zur Verwendung mit einem Feldbussystem, insbesondere einem CAN-Bussystem (16), einem FlexRay-Bussystem, einem CAN-FD-Bussystem, eine MOST-Bussystem, LIN-Bussystem, Ethernet-Bussystem oder dergleichen.

12. Empfänger (30) eines Steuernetzwerks (10) mit wenigstens einem Bussystem (16) zum Empfang von Daten wenigstens eines Messgrößenaufnehmers (18), **dadurch gekennzeichnet, dass** der Empfänger (30) wenigstens einen Dekomprimierer (36) umfasst zum Dekomprimieren (52) wenigstens eines Teils von komprimierten Daten des wenigstens einen Messgrößenaufnehmers (18).

13. Messgrößenaufnahmevorrichtung (14) mit wenigstens einem Messgrößenaufnehmer (18) und wenigstens einem Sender (20), insbesondere nach einem der Ansprüche 9 bis 11, insbesondere zur Durchführung des Verfahrens nach einem der Ansprüche 1 bis 8, **dadurch gekennzeichnet, dass** die Messgrößenaufnahmevorrichtung (14) wenigstens einen Komprimierer (26) umfasst zum Komprimieren (26) wenigstens eines Teils der Daten des wenigstens einen Messgrößenaufnehmers (18).

14. Steuernetzwerk (10) mit wenigstens einer Steuereinrichtung (12) und wenigstens einem Messgrößenaufnehmer (18), welche über wenigstens ein Bussystem (16) zur Datenübertragung (48) verbunden sind, insbesondere zur Durchführung des Verfahrens nach einem der Ansprüche 1 bis 8, **dadurch gekennzeichnet, dass** bezüglich des Bussystems (16) aufseiten des wenigstens einen Messgrößenaufnehmers (18) wenigstens ein Komprimierer (26) zum Komprimieren (26) wenigstens eines Teils von Daten des wenigstens einen Messgrößenaufnehmers (18) angeordnet ist und aufseiten der wenigstens einen Steuereinrichtung wenigstens ein Dekomprimierer (36) zum Dekomprimieren (52) wenigstens eines Teils der komprimierten Daten des wenigstens eine Messgrößenaufnehmers (18) angeordnet ist.
